Europäisches Patentamt

European Patent Office

Office européen des brevets

(19)

(11) Publication number: **0 439 371 A2**

(12)

# EUROPEAN PATENT APPLICATION

(21) Application number: 91300598.9

(22) Date of filing: 25.01.91

(51) Int. Cl.⁵: **G03F 7/022**, G03F 7/004, G03F 7/039

(30) Priority: 26.01.90 US 471163

(43) Date of publication of application:
31.07.91 Bulletin 91/31

(84) Designated Contracting States:
DE FR GB IT NL

(71) Applicant: HOECHST CELANESE
CORPORATION
Route 202-206 North
Somerville, New Jersey (US)

(72) Inventor: McFarland, Michael J.
R.D. 3 Box 247
Washington, New Jersey (US)

(74) Representative: De Minvielle-Devaux, Ian
Benedict Peter et al
CARPMAELS & RANSFORD 43, Bloomsbury
Square
London WC1A 2RA (GB)

(54) Photoresist containing aliphatic di- and tri-esters of aliphatic and aromatic di- and tri-acids and alcohols.

(57) A photosensitive composition containing an alkali soluble resin, a photosensitizer compound and a plasticizer which is selected from aliphatic di- and tri-esters of aliphatic and aromatic di- and tri-acids and alcohols in a solvent mixture. After drying and imagewise exposing, the composition is developed to produce a positive photoresist image.

EP 0 439 371 A2

EP 0 439 371 A2

## BACKGROUND OF THE INVENTION

The present invention relates to light sensitive photoresist compositions and particularly to compositions containing aqueous alkali soluble resins together with sensitizing agents. It is well known in the art to produce positive photoresist formulations such as those described in United States Patents 3,666,473 : 4,115,128 and 4,173,470. These include alkali soluble phenol-formaldehyde novolak resins together with light sensitive materials, usually a substituted naphthoquinone diazide compound. The resins and sensitizers are dissolved in an organic solvent or mixture of solvents and are applied as a thin film or coating to a substrate suitable for the particular application desired. The resin component of these photoresist formulations is soluble in aqueous alkaline solutions, but the naphthoquinone sensitizer is not. Upon imagewise exposure of the coated substrate to actinic radiation the sensitizer is rendered more soluble than the unexposed areas. This difference in solubility causes the exposed areas of the photoresist coating to be dissolved when the substrate is immersed in an alkaline developing solution while the unexposed areas are not removed, thus producing a positive image on the substrate.

In the preparation of integrated circuits, the coated, exposed and developed substrate will be subjected to treatment by an etchant. The photoresist coating protects the coated areas of the substrate from the etchant and thus it is only able to affect the uncoated areas of the substrate, which in the case of a positive photoresist, correspond to the areas that were exposed to actinic radiation. Thus, a pattern can be created on the substrate which corresponds to the pattern on the exposure mask that was used to selectively expose the substrate prior to development. The pattern of the photoresist on the substrate produced is useful in the manufacture of miniaturized electronic components.

Photoresists are generally categorized as being either positive working or negative working. In a negative working resist composition, the imagewise light struck areas harden and form the image areas of the resist after removal of the unexposed areas with a developer. In a positive working resist the exposed areas are the non-image areas. The light struck parts are rendered soluble in aqueous alkali developers. While negative resists are the most widely used for industrial production of printed circuit boards, positive resists are capable of much finer resolution and smaller imaging geometries. Hence positive resists are the choice for the manufacture of densely packed integrated circuits.

Positive working photoresists consist of a photosensitizer which is usually an o-quinone diazide, a water insoluble, aqueous alkaline soluble polymeric binder resin such as a novolak and a solvent. It may additionally contain minor amounts of additional components such as anti-striation agents, dyes, etc. One problem with the polymeric binder in such compositions is that while the polymers have excellent thermal stability characteristics, they may tend to be somewhat brittle. This can result in cracking and particulate contamination of semiconductor wafers to which the photoresist is applied. One might expect that the inclusion of a plasticizer would retard cracking in thin polymer films on semiconductor wafers. However, many plasticizers also impart unwanted side properties in addition to desired plasticity and crack prevention. It has been unexpectedly found that the inclusion of aliphatic di- and tri-esters of aliphatic and aromatic di- and tri-acids and alcohols demonstrates several unexpected benefits including improved film retention after development in non-irradiated areas of positive photoresist, and improved clean out of microlithographic features in the irradiated areas. Those skilled in the photoresist art sometimes call film retention after development in the non-irradiated areas "percent thinning" and in this case the plasticizer would be said to reduce percent thinning for a specific sensitivity. In one embodiment of the invention, film retention is observed to increase from 96% for the unplasticized resist to over 99% for the plasticized resist and in another embodiment, film retention increases from 94% unplasticized to over 98% plasticized. Improved film retention is important as it provides the microlithographer with a significant increase in process latitude. Resist systems with low film retention, i.e. high percent thinning place overly tight restrictions on the process engineer who must adjust other lithographic parameters.

Since the lithographic pattern made in the resist is subsequently transferred to the semiconductor by etching, it is critical that the pattern be as flawless as possible. As device geometries become increasingly smaller, one of the most common problems is failure to fully clear out the finest geometries. The addition of the instant additives to resist compositions improves clean out considerably. It is theorized that part of this effect may be due to decreased optical absorbance in the deep ultraviolet region due to sensitizer dilution in the plasticized resist. The photosensitizer is the only strongly absorbing species in the resist and since its concentration is reduced in the dried, plasticized film, the film is less absorbing. This translates into increased light penetration and therefore proportionally greater amounts of photochemistry activity near the resist substrate interface. It has been found that when the additive is included in certain resist compositions that could not be cleared out even with overexposure, they may be easily cleared with normal development. It is believed that these results indicate an additional mechanism for feature clean out is in effect in addition to the decreased optical density noted above. It is observed that that these lithographic advantages can be achieved without any serious draw-

2

backs that can be ascertained. The additive appears to be fully compatible with the other resist components. Film spinning uniformity is not changed nor is resist temperature response. It appears that features formed in plasticized resist show thermal flow at about the same point as their unplasticized analogues.

The invention provides photoresist compositions comprising minor amounts of aliphatic di- and tri-esters of aliphatic and aromatic di- and tri-acids and alcohols. The most preferred compounds are di(2-ethylhexyl)adipate (M.W. 371, liquid) and dioctyl adipate.

## SUMMARY OF THE INVENTION

The invention provides a positive working photoresist composition which comprises in admixture, a water insoluble binder resin which is either aqueous alkali soluble or becomes aqueous alkali soluble upon exposure, in an amount sufficient to form a uniform film of the composition components when it is coated on a substrate and dried ; a photosensitive component selected from the group consisting of o-quinone diazides, onium salts, compounds having a diazo-1,3 dione group, and a combination of a compound capable of generating an acid upon exposure to sufficient activating energy, and a compound containing at least one C-O-C bond which can be split by an acid, said photosensitive component being present in an amount sufficient to uniformly photosensitize the composition ; a compound selected from the group consisting of aliphatic di- and tri-esters of aliphatic and aromatic di- and tri-acids and alcohols in an amount sufficient to increase film retention in non-irradiated areas and increase film removal in irradiated areas of the photoresist composition when a film of the composition it is coated on a substrate, dried, exposed to activating energy and developed, compared to the same composition without said compound ; and a solvent in an amount sufficient to dissolve the composition components.

The invention also provides a photographic element comprising a dried film of the foregoing composition on a substrate. The invention further provides a method for producing a photographic image comprising imagewise exposing and developing the aforesaid photographic element with an aqueous alkaline solution.

## DETAILED DESCRIPTION OF THE PREFERRED EMBODIMENT

In the production of the photographic element of the present invention, one coats and dries the foregoing positive photosensitive composition on a suitable substrate. In the preferred embodiment the composition contains a solvent, a water insoluble, binder resin which is either aqueous alkali soluble or becomes aqueous alkali soluble upon exposure, photosensitizer and plasticizer.

The binding resins include the classes known as the novolaKs, substituted and unsubstituted polyvinyl phenols, maleimide homopolymers and copolymers described in U.S. patent applications 06/547,815 filed November 11, 1983 ; 06/832,116 filed February 24, 1986 and 07/052,950 filed May 22, 1987 : t-butylstyrene maleimide copolymers, and the poly(p-tert-butoxycarbonyloxystyrenes) described in U.S. 4,491,620 all of which are incorporated herein by reference.

The production of novolak resins, which may be used for preparing photosensitive compositions, is well known in the art. A procedure for their manufacture is described in Chemistry and Application of Phenolic Resins, Knop A. and Scheib, W. ; Springer Verlag, New York, 1979 in Chapter 4 which is incorporated herein by reference. Polyvinyl phenols are taught in U.S. 3,869,292 and 4,439,516, which are incorporated herein by reference. Useful binder resins include copolymers of styrene, t-butyl styrene, alpha-methylstyrene or 2,4-di($C_1$-$C_5$ alkyl)styrene and maleimide and, optionally their terpolymers with N-($C_1$-$C_5$ alkyl)maleimide as described in U.S. patent application 06/547,815. Useful binders also include the foregoing copolymers wherein a portion of the N-H groups of the maleimide have been replaced with an acid labile group such as a tert-butoxy carbonyl group as taught in U.S. Patent application serial number 06/832,116. Still further useful binder resins are polymers containing imide groups blocked by a methylol group or substituted methylol group and further blocked to form an acetal or ketal moiety as taught in U.S. patent application 07/052,950. Preferred are the polymers disclosed in application U.S. Serial No. 06/832,116. Examples of such polymers are N-tert-butyloxycarbonyl maleimide/styrene copolymer, N-tert-butyloxycarbonyl maleimide homopolymer, N-tert-butyloxycarbonyl maleimide/vinyl ether copolymers where the vinyl ether is aliphatic from 3 (methyl vinyl ether) to 20 , (octadecylvinyl ether) carbon atoms, N-tert-butyloxycarbonyl maleimide/2,4-disubstituted styrene copolymers where the styrene is substituted at the 2 and 4 positions with, independently, C1 to C5 alkyl groups or hydrogen. Other polymers which may be used include those in which a phenol containing polymer has the hydroxyl functionalities blocked with an acid-labile group such as poly(tert-butyloxycarbonyl-alpha-alkyl styrene) or a copolymer thereof, poly(tert-butyloxycarbonyloxy styrene) or a copolymer thereof, or polymers containing other acidic imide functionalities (-CO-NH-CO-) blocked by an acid labile group such as poly(dimethyl-N-tert-butyloxycarbonyl glutarimide), or polymers containing carboxylic acid functionalities blocked by an acid labile group such

3

as poly(tert-butyl p-vinylbenzoate) or a copolymer thereof, poly(tert-butyl methacrylate) or a copolymer thereof, and the like. Other blocking groups may be present on the polymers to yield materials useful for the method of the invention.

O-quinone diazides are well known to the skilled artisan as demonstrated by Light Sensitive Systems, Kosar, J. ; John Wiley & Sons, New York, 1965 in Chapter 7.4 which is also incorporated herein by reference. These sensitizers which comprise a component of the present resist compositions of the present invention are preferably selected from the group of substituted naphthoquinone diazide sensitizers which are frequently used in the art in positive photoresist formulations. Such sensitizing compounds are disclosed, for example, in United States Patents 2,797,213 ; 3,106,465 ; 3,148,983 ; 3,130,047 ; 3,201,329 ; 3,785,825 ; and 3,802,885, which are incorporated herein by reference.

The preferred photosensitizer is a 1,2 quinone diazide -4- or -5-sulfonic acid ester of a phenolic derivative. It presently appears that the number of fused rings is not important for this invention but the position of the sulfonyl group is important. That is, one may use benzoquinones, naphthoquinones or anthroquinones as long as the oxygen is in the 1 position, diazo is in the 2 position and the sulfonyl group is in the 4 or 5 position. Likewise the phenolic member to which it is attached does not appear to be important. For example it can be a cumylphenol derivative as taught in U.S. 3,640,992 or it can be a mono-, di-, or tri-hydroxyphenyl alkyl ketone or benzophenone as shown in U.S. 4,499,171. Both of these patents are incorporated herein by reference.

The photosensitive component may also comprise a combination of a compound capable of generating an acid upon exposure to actinic radiation and a compound containing at least one C-O-C bond which can be split by an acid. Such a combination of compounds non-exclusively includes those taught in U.S. 4,101,323, incorporated herein by reference. Onium salts include sulfonium, diazonium and iodonium salts. Sulfonium salts are described in U.S. 4,537,854 ; diazonium salts are described in Kosar. Iodonium salts are described in U.S. Patent 4,603,101. Compounds having the diazo-1,3 dione group are disclosed in U.S. 4,522,911 ; 4,339,322: 4,284,706 ; 4,622,283 ; 4,735,885 and 4,626,491 which are incorporated by reference.

The plasticizers which are useful for this invention are aliphatic di- and tri-esters of aliphatic and aromatic di- and tri-acids and alcohols. The most preferred compounds are di(2-ethylhexyl)adipate and dioctyl adipate. It is preferably present in the photosensitive composition in an amount of from about 0.5% to about 20% based on the weight of the non-solvent parts of the composition. A more preferred range is from about 2% to about 18% by weight.

The positive photoresist composition is formed by mixing the ingredients in a suitable solvent composition. In the preferred embodiment the resin is preferably present in the overall composition in an amount of from about 75% to about 98.5% based on the weight of the solid, i.e. non-solvent parts of the composition. A more preferred range of resin would be from about 80% to about 90% and most preferably from about 82% to about 85% by weight of the solid composition parts. The photosensitive component is preferably present in an amount ranging from about 1% to about 25% based on the weight of the solid, i.e., non-solvent parts of the composition. A more preferred range of the photosensitive component would be from about 1% to about 20% and more preferable from about 10% to about 18% by weight of the solid composition parts. In manufacturing the composition the resin, plasticizer and photosensitive components are mixed with such solvents as propylene glycol alkyl ether or its acetate, butyl acetate, diglyme, xylene, ethylene glycol monoethyl ether acetate, and most preferably propylene glycol monomethyl ether and propylene glycol monomethyl ether acetate, among others.

Additives such as colorants, dyes, anti-striation agents, leveling agents, adhesion promoters, speed enhancers, and such surfactants as non-ionic surfactants may be added to the solution of resin, sensitizer, and solvent before the solution is coated onto a substrate.

Examples of dye additives that may be used together with the photoresist compositions of the present invention include Methyl Violet 2B (C.I. No. 42535), Crystal Violet (C.I. 42555), Malachite Green (C.I. No. 42000), Victoria Blue B (C.I. No. 44045) and Neutral Red (C.I. No. 50040) in an amount of from about 1.0 to about 10.0 percent, based on the combined weight of the solid parts of the composition. The dye additives help provide increased resolution by inhibiting back scattering of light off the substrate.

Anti-striation agents may be used up to five percent weight level, based on the combined weight of solids. Adhesion promoters which may be used include, for example, beta-(3,4-epoxy-clohexyl)-ethyltrimethoxysilane; p-methyl-disilanemethyl methacrylate ; vinyltrichlorosilane ; and gamma-amino-propyl triethoxysilane up to a 4.0 percent based on the combined weight of solids. Speed enhancers that may be used include, for example, picric acid, nicotinic acid or nitrocinnamic acid at up to 20 percent, based on the combined weight of resin and solids. These enhancers tend to increase the solubility of the photoresist coating in both the exposed and unexposed areas, and thus they are used in applications when speed of development is the overriding consideration even though some degree of contrast may be sacrificed ; i.e., while the exposed areas of the photoresist coating will be dissolved more quickly by the developer, the speed enhancers will also cause a larger loss of photoresist coating from the unexposed areas. The coating solvents may be present in the overall composition in an amount of up to about 95% by weight of the composition. Preferably, the solvent content is such that the total solids comprise about 5% to about 50% by weight of the overall composition. Non-ionic surfactants that may be used include, for example, nonylphenoxy poly(ethyleneoxy)ethanol ; octylphenoxy(ethyleneoxy)ethanol ; and dinonyl phenoxy poly(ethyleneoxy)ethanol at up to 10 percent based on the combined weight of solids.

The resist solution can be applied to a substrate by any usual method enployed in the photoresist art, including dipping, spraying, whirling and spin coating. When spin coating, for example, the resist solution can be adjusted for the percentage of solids content in order to provide coatings of the desired thickness given the type of spinning equipment utilized and the amount of time allowed for the spinning process. Suitable substrates include silicon, aluminum or polymeric resins, silicon dioxide, doped silicon dioxide, silicon nitride, tantalum, copper, polysilicon, ceramics, aluminum/copper mixtures, gallium arsenide and other such Group III/V compounds. The substrate may have an adhesion promoted layer of a suitable composition such as hexa-alkyldisilazane.

The photoresist coatings produced by the above described procedure are particularly suitable for application to thermally grown silicon/silicon dioxide-coated wafers such as are utilized in the production of microprocessors and other miniaturized integrated circuit components. An aluminum/aluminum oxide wafer can be used as well. The substrate may also comprise various polymeric resins especially transparent polymers such as polyesters. After the resist composition solution is coated onto the substrate, the substrate is temperature treated at approximately 20° to 100°C. This temperature treatment is selected in order to reduce and control the concentration of residual solvents in the photoresist while not causing substantial thermal degradation of the photosensitizer. In general one desires to minimize the concentration of solvents and thus this temperature treatment is conducted until substantially all of the solvents have evaporated and a thin coating of photoresist composition, on the order of a micron in thickness, remains on the substrate. This treatment is normally conducted at temperatures in the range of from about 20° to about 100°C. In a preferred embodiment the temperature is conducted at from about 50° to about 90°C. A more preferred range is from about 70° to about 90°C. This treatment is conducted until the rate of change of solvent removal becomes relatively insignificant. The temperature and time selection depends on the resist properties desired by the user as well as equipment used and commercially desired coating times. Commercially acceptable treatment times for hot plate treatment are those up to about 3 minutes, more preferably up to about 1 minute. In one example, a 30 second treatment at 90° is useful. The coating substrate can then be exposed to actinic radiation, especially ultraviolet radiation, in any desired pattern, produced by use of suitable masks, negatives, stencils, templates, etc. in a manner well known to the skilled artisan. Exposure may be by electron beam or x-ray but the most preferred exposure is with ultraviolet radiation, especially deep ultraviolet radiation, i.e. at a wavelength of from about 220 to about 260 nm.

The exposed resist-coated substrate is next immersed in a suitable developing solution. The solution is preferably agitated, for example, by nitrogen burst agitation. The substrates are allowed to remain in the developer until all, or substantially all, of the resist coating has dissolved from the exposed areas. Suitable developers include aqueous alkaline solutions such as those including sodium hydroxide, and tetramethyl ammonium hydroxide as are well known in the art. 0.1N to 0.3N solutions are useful. The more dissolution rate modifier that is added, the stronger the developer concentration required. After removal of the coated wafers from the developing solution, an optional post-development heat treatment or bake may be employed to increase the coating's adhesion and chemical resistance to etching solutions and other substances. The post-development heat treatment can comprise the oven baking of the coating and substrate below the coating's softening point. In industrial applications, particularly in the manufacture of microcircuitry units on silicon/silcon dioxide-type substrates, the developed substrates may be treated with a buffered, hydrofluoric acid base etching solution. The resist compositions of the present invention are resistant to acid-base etching solutions and provide effective protection for the unexposed resist-coated areas of the substrate.

The following non-limiting examples serve to illustrate the invention.

Example 1

Maleimide-t-butylstyrene copolymer

A 250 ml, 3 neck flask is charged with 12.11g maleimide, 120 ml distilled cyclohexanone (water white), 1.8 ml dodocane-thiol, 22,7ml (20g) p-t-butylstyrene and 152 mg azobisisobutyronitrile. The mixture is deoxygenated by bubbling argon through the mixture for about 3 minutes. The flask is closed under an atmosphere of argon and heated to 62°C in a preheated oil bath for 4 1/2 hours. The mixture is poured into 900 ml pentane, filtered and washed with pentane and thereafter dried overnight in a 72°C oven. 30.73g of product is obtained (95.7% yield).

### Example 2

A 12g photoresist is produced by admixing 7 parts of the resin of example 1, 1 part of a sensitizer which is the condensation product of 2,4 dihydroxybenzophenone with 2-diazo-1-naphthol-4-sulfonyl chloride and diglyme to attain a 28% solids solution which is filtered to 0.2um. The resist is divided into 2.0g batches in clean vials and di(2-ethylhexyl) adipate (mw 371) is added and mixed into the resist in the following amounts.

| Sample | % Plasticizer in Solution | Amount of Plasticzer in Solution | Spin Speed for a 1um Film (rpm) |
|---|---|---|---|
| 1. | 0% | 0g | 4300 |
| 2. | 3% | 0.061g | 4700 |
| 3. | 5% | 0.110g | 5000 |
| 4. | 7% | 0.151g | 5300 |
| 5. | 10% | 0.220g | 5800 |

The resists are coated onto silicon wafers having been first treated for 10 minutes with a hexamethyl disilazane adhesion promoter. The resists are baked for 40 minutes at 80°C and exposed for 160mJ/cm$^2$ with a 260 broad band filter on an Optoline step tablet. They are then developed with a 0.13N potassium hydroxide solution with the following results.

Sample :

1. Development is for 45 seconds and there is a 96% film retention. The image features are acceptable but the edge is badly cracked. Clear to 30% T (48mJ/cm$^2$).

2. Development is for 50 seconds and there is a 94% film retention. The image features are acceptable. There are some cracks at the edge but fewer than with Sample 1. Clear to 30% T.

3. Development is for 60 seconds and a 99.0% film retention in the image area is noticed. The image features are acceptable. The edge is not cracked but abrasion is evident. Some ghosting is present. Clear to 30%T.

4. Development is for 50 seconds and a 99.3% film retention is noticed. The image features are acceptable and there is no ghosting. Very few small cracks are present along the edge with abrasion. Clear to 30%T.

5. Development is for 45 seconds and a 98.7% film retention is noticed. The image features are acceptable. The edge has a few cracks nearby flaws. Flaws are roughly circular and have a different texture than the resist. Not all flaws cause cracks. There are some very small beads near the inner side of the edge bead. Clear to 30%T.

SEM photographs indicate a better cleaning of the image features when the plasticizer is added to the resist.

### Example 3

#### Maleimide-p-t-butylstyrene copolymer

A 250ml 3 nicked flask is charged with 120ml of distilled cyclohexanone (water white), 12.11g maleimide, 0.9ml 1-dodecanethiol and 22.7ml p-t-butylstyrene. This composition is mixed under argon then 152mg of azobisisobutyronitrile are added and the mixture warmed to 62°C in a preheated oil bath for 3 hours 35 minutes. It is then poured into pentane, washed with pentane and air dried. It is then oven dried at 70°C overnight. Recovery is 31.4g of white solid (98% yield).

### Example 4

A photoresist is prepared by mixing 3.83g of diglyme, 1.0 g of the resin from example 3, 0.143 g of the sensitizer from example 2 and 0.374 g of di(2-ethylhexyl)adipate. The resist is spun on hexamethyl disilazane vapor treated wafers at 3200 rpm and baked for 40 minutes at 80°C. It is exposed to 160 mJ/cm$^2$ at 260 nm (broad band) through an Optoline tablet. It is developed for 1 minute in a 0.13N potassium hydroxide dip. A 97.9% film retention is noticed. There is no scum visible and no edge cracks. Clear to 30-35%T (48-56 mJ/cm$^2$).

## Example 5

Example 4 is repeated except development is for 30 seconds in a 0.17N potassium hydroxide solution. No scumming and a few cracks are noticed. Comparable development of the same composition without the di(2-ethylhexyl)adipate shows an increased scum level.

## Example 6

Example 4 is repeated except development is for 35 seconds in 0.17N potassium hydroxide. 98.5% film retention is observed. There is no scum noticed, very few cracks and clear to 48 mJ/cm$^2$.

## Example 7

Example 4 is repeated except development is for 17 seconds in 0.20N potassium hydroxide. There is a 97.8% film retention. No scum or cracking is seen. Clear to 48 mJ/cm$^2$.

## Example 8

Example 5 is repeated. A 98.3% film retention is observed. No scum or cracks are noticed. Clear to 48 mJ/cm$^2$.

## Example 9

Example 5 is repeated except exposure is at 60 mJ/cm$^2$ with a BRL resolution mask. Development is for 30 seconds with 0.17N potassium hydroxide. A 98.0% film retention is noticed.

## Example 10

Example 2 is repeated except development is with tetramethyl ammonium hydroxide with the following results.

Sample :

1. Development is for 70 seconds. A 94.0% film retention is noticed. Image features are acceptable but the edge is cracked. Clear to 30%T (48 mJ/cm$^2$).
2. Development is for 70 seconds. 89.9% film retention is observed. Image features are acceptable but the edge shows cracks and abrasion. Clear to 30%T.
3. Development is for 70 seconds. 93-98% film retention is noticed. Image features are acceptable with very few cracks. Clear to 30%T. Severe ghosting is noticed. There is 93% film retention over most of the wafer with only one area not ghosted at 98% retention.
4. Development is for 63 seconds. 98.7% film retention is noticed. Image features are acceptable. Clear to 30%T. Very little edge crack is observed but abrasion is present.
5. Development is for 70 seconds. 98.5% film retention is noticed. Image features are acceptable. Slight ghosting is observed. The edge shows almost no cracks. Clear to 30%T.

## Claims

1. A positive working photoresist composition which comprises in admixture a water insoluble binder resin which is either aqueous alkali soluble or becomes aqueous alkali soluble upon exposure, in an amount sufficient to form a uniform film of the composition components when it is coated on a substrate and dried; a photosensitive component selected from o-quinone diazides, onium salts, compounds having a diazo-1,3 dione group, and a combination of a compound capable of generating an acid upon exposure to sufficient activating energy and a compound containing at least one C-O-C bond which can be split by an acid, said photosensitive component being present in an amount sufficient to uniformly photosensitize the composition ; a plasticizer compound selected from aliphatic di- and tri-esters of aliphatic and aromatic di- and tri-acids and alcohols in an amount sufficient to increase film retention in non-irradiated areas and increase film removal in irradiated areas of the photoresist composition when a film of the composition is coated on a substrate, dried, exposed to activating energy and developed, compared to the same composition without said plasticizer compound ; and a solvent in an amount sufficient to dissolve the composition components.

2. The composition of claim 1 wherein the plasticizer is di(2-ethylhexyl)adipate or dioctyl adipate.

3. The composition of claim 1 or 2 wherein the photosensitive component is an o-quinone diazide.

4. The composition of claim 1 or 2 wherein the photosensitive component is a trihydroxybenzophenone-1,2-naphthoquinone diazide-4 or 5-sulfonic acid trisester.

5. The composition of any of claims 1-4 wherein the binder resin in selected from novolaks, polyvinyl phenols, copolymers of styrene, 4-methyl styrene, 4-ethyl styrene, t-butyl styrene, alpha-methylstyrene or 2,4-di($C_1$-$C_5$ alkyl) styrene and maleimide and their terpolymers with N-($C_1$-$C_5$ alkyl)maleimide, the foregoing copolymers wherein a portion of the N-H groups of the maleimide have been replaced with an acid labile group, and polymers containing imide groups blocked by a methylol group or substituted methylol group and further blocked to form an acetal or ketal moiety.

6. The composition of any of claims 1-5 wherein the amount of binder resin is from 75% to 98.5%, the amount of photosensitive component is from 1% to 20% and the amount of plasticizer is from 0.5% to 20%, based on the weight of the non-solvent parts of the photosensitive composition.

7. The composition of any of claims 1-6 further comprising one or more compounds selected from colorants, dyes, anti-striation agents, leveling agents, adhesion promoters, speed enhancers, and surfactants.

8. The composition of any of claims 1-7 wherein the solvent comprises propylene glycol alkyl ether or propylene glycol alkyl ether acetate or diglyme.

9. The composition of claim 8 wherein the solvent comprises propylene glycol monomethyl ether or propylene glycol monomethyl ether acetate or diglyme.

10. A photographic element which comprises a substrate and a dried photosensitive composition substantially uniformly coated on said substrate which photosensitive composition comprises in admixture a water insoluble binder resin which is either aqueous alkali soluble or becomes aqueous alkali soluble upon exposure, in an amount sufficient to form a uniform film of the composition components when it is coated on a substrate and dried ; a photosensitive component selected from o-quinone diazides, onium salts, compounds having a diazo-1,3 dione group, and a combination of a compound capable of generating an acid upon exposure to sufficient activating energy and a compound containing at least one C-O-C bond which can be split by an acid, said photosensitive component being present in an amount sufficient to uniformly photosensitize the composition ; and a plasticizer compound selected from aliphatic di- and tri-esters of aliphatic and aromatic di- and tri-acids and alcohols in an amount sufficient to increase film retention in non-irradiated areas and increase film removal in irradiated areas of the photoresist composition when a film of the composition is coated on a substrate, dried, exposed to activating energy and developed, compared to the same composition without said plasticizer compound.

11. The element of claim 10 wherein the composition is in accordance with any of claims 2-7.

12. The element of claim 10 or 11 wherein the substrate is selected from silicon, aluminum, polymeric resins, silicon dioxide, doped silicon dioxide, silicon nitride, tantalum, copper, polysilicon, ceramics, aluminum/copper mixtures, gallium arsenide and Group III/V compounds.

13. The element of claim 12 further comprising a layer of an adhesion promoting composition between the substrate and the photosensitive composition.

14. The element of claim 13 wherein the adhesion promoting composition contains hexa-alkyldisilazane.

15. A process for preparing a photographic image which comprises
    (a) forming a composition as defined in any of claims 1-9,
    (b) coating said composition on a substrate ;

(c) heating said coated substrate at a temperature of from 20°C to 100°C until substantially all of said solvent is dried off ;

(d) imagewise exposing the resulting composition to ultraviolet, electron beam, ion beam or x-ray radiation ; and

(e) removing the non-image areas of the resulting composition with an aqueous alkaline developer solution.

16. The process of claim 15 wherein said exposing step is conducted with ultraviolet radiation in the range of from 190 to 450 nm.

17. The process of claim 16 wherein said exposing step is conducted with ultraviolet radiation in the range of from 190 to 300 nm.

18. The process of any of claims 15-17 wherein said developer comprises sodium hydroxide and/or tetramethyl ammonium hydroxide.